(19) **Europäisches Patentamt**
**European Patent Office**
**Office européen des brevets**

(11) **EP 3 171 183 B1**

(12) **FASCICULE DE BREVET EUROPEEN**

(45) Date de publication et mention de la délivrance du brevet:
**12.12.2018 Bulletin 2018/50**

(51) Int Cl.:
*G01R 23/10* *(2006.01)*      *H03D 13/00* *(2006.01)*
*H03L 7/08* *(2006.01)*      *H03L 7/18* *(2006.01)*
*G01R 23/02* *(2006.01)*

(21) Numéro de dépôt: **16162144.6**

(22) Date de dépôt: **24.03.2016**

(54) **PROCÉDÉ ET DISPOSITIF DE MESURE DE LA FRÉQUENCE D'UN SIGNAL**

VERFAHREN UND VORRICHTUNG ZUR FREQUENZMESSUNG EINES SIGNALS

METHOD AND DEVICE FOR MEASURING THE FREQUENCY OF A SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.11.2015 FR 1561153**

(43) Date de publication de la demande:
**24.05.2017 Bulletin 2017/21**

(73) Titulaire: **STMICROELECTRONICS SA**
**92120 Montrouge (FR)**

(72) Inventeurs:
• **HOUDEBINE, Marc**
  **38920 CROLLES (FR)**
• **DEDIEU, Sébastien**
  **38660 LA TERRASSE (FR)**

(74) Mandataire: **Casalonga**
**Casalonga & Partners**
**Bayerstraße 71/73**
**80335 München (DE)**

(56) Documents cités:
**EP-A1- 0 762 628**      **EP-A1- 1 538 451**
**EP-A1- 1 835 621**      **CN-U- 203 313 155**
**DE-A1-102010 046 880**      **FR-A1- 2 905 040**
**US-A- 4 786 861**      **US-A1- 2010 127 739**
**US-A1- 2010 188 158**      **US-B1- 7 902 891**

• **LIOBE J ET AL: "A Novel Application of FM-ADC Toward the Self-Calibration of Phase-Locked Loops", IEEE TRANSACTIONS ON CIRCUITS AND SYSTEMS I: REGULAR PAPERS, IEEE, US, vol. 55, no. 9, 1 octobre 2008 (2008-10-01), pages 2491-2504, XP011333237, ISSN: 1549-8328, DOI: 10.1109/TCSI.2008.920074**

EP 3 171 183 B1

**Description**

Des modes de mise en oeuvre et de réalisation de l'invention concernent les mesures de fréquence de signaux périodiques.

L'invention s'applique par exemple mais non limitativement à l'étalonnage (« calibration » en langue anglaise) du gain d'un oscillateur commandé en tension (« VCO », Voltage Controlled Oscillator selon la dénomination anglo-saxonne) dans les boucles à verrouillage de phase (« PLL », Phase Locked Loop).

Une boucle à verrouillage de phase est un système bouclé capable de délivrer un signal dont la fréquence est asservie à celle d'un signal de référence.

Plus précisément et classiquement, une boucle à verrouillage de phase comprend notamment un comparateur de phase recevant sur une entrée un signal de référence, et un oscillateur commandé en tension dont l'entrée de commande est couplée à la sortie du comparateur de phase et dont la sortie, rebouclée sur une autre entrée du comparateur de phase après une division de fréquence, délivre un signal de sortie asservi en fréquence et en phase sur celle du signal de référence mais ayant généralement une fréquence plus importante que celle du signal de référence.

Lors d'un étalonnage en gain de l'oscillateur commandé en tension, on détermine la fréquence du signal de sortie de l'oscillateur pour deux valeurs différentes de la tension d'entrée (généralement obtenues à partir de deux mots numériques différents respectivement représentatifs desdites deux tensions différentes), et on effectue le rapport entre la différence de ces deux fréquences de sortie et la différence des deux mots numériques.

On connait des méthodes de calcul d'une fréquence d'un signal à partir de la fréquence d'un signal de référence, utilisant notamment une moyenne des nombres de périodes du premier signal comptabilisés durant un nombre donné de périodes du signal de référence. Cependant, plus les mesures doivent être précises, plus ces méthodes sont coûteuses en temps.

A titre d'exemple, pour une précision de mesure de 62,5KHz, la détermination précise de la fréquence d'un signal qui se situe par exemple aux alentours de 2,4GHz, à partir d'un signal de référence ayant une fréquence de 16MHz nécessite 256 périodes du signal de référence, soit 16 microsecondes.

Ceci conduit à une durée importante de la phase d'étalonnage du gain.

Or certaines applications de communication basse consommation, comme par exemple le Bluetooth basse consommation (« BLE », Bluetooth Low Energie), nécessitent une mise en route plus rapide de la boucle à verrouillage de phase, et donc en particulier une durée courte de la phase d'étalonnage du gain de l'oscillateur afin notamment d'économiser l'énergie de la batterie.

US 7,902,891 B1 divulgue un modulateur à deux points utilisant un oscillateur contrôlé en tension et un procédé de traitement d'étalonnage.

Ainsi, selon un mode de mise en oeuvre et de réalisation il est proposé une détermination simple et rapide d'une fréquence d'un signal à partir d'un signal de référence.

La présente invention concerne donc un procédé tel que décrit dans la revendication 1 ainsi qu'un dispositif tel que décrit dans la revendication 12. Des modes de réalisation avantageux sont décrits dans les revendications dépendantes.

Selon un aspect il est proposé un procédé de détermination de la fréquence d'un signal à partir d'un signal périodique de référence, comprenant

a) un comptage du nombre de périodes entières dudit signal pendant une première période du signal de référence (La première période du signal de référence est par exemple la période qui commence après un instant de début de la détermination de la fréquence dudit signal),
b) une répétition de l'étape a) pour chaque période du signal de référence jusqu'à l'expiration d'une première durée égale à une première quantité de périodes du signal de référence, et
c) une détermination d'une première moyenne desdits nombres,
d) R répétitions d'au moins une partie des étapes a) à c), en décalant à chaque répétition le début du comptage de l'étape a) d'au moins une période du signal de référence, et en prenant éventuellement en compte pour l'étape b) et pour l'étape c) des nombres de périodes entières dudit signal déjà comptés lors d'au moins un groupe précédent d'étapes a) à b).

En effet dans l'étape d), il serait possible à chaque répétition de l'étape b) de recompter des nombres déjà comptés lors d'une répétition précédente. Cela étant comme on le verra ci-après, il est possible de conserver les nombre déjà comptés lors des répétitions précédentes et de ne compter lors d'une répétition courante que le nombre de périodes entières dudit signal pendant la nouvelle période courante du signal de référence, et bien sûr d'utiliser ce nouveau nombre et les nombres déjà comptés pour effectuer ladite première moyenne.

Le procédé selon cet aspect comporte également :

e) une détermination d'une deuxième moyenne de toutes les premières moyennes ainsi obtenues, et
f) une détermination de la fréquence dudit signal à partir de ladite deuxième moyenne et de la fréquence du signal de référence.

Ainsi, il est possible par l'utilisation de ces R moyennes glissantes de déterminer la fréquence dudit signal avec une précision élevée sans que cela n'entraîne une augmentation importante de la durée de ladite détermination de fréquence.

Avantageusement, les étapes a), b), et c) sont effectués en parallèle.

Les étapes a) à e) peuvent être mises en oeuvre par l'application de la formule suivante :

$$M2 = \frac{1}{R} * (\sum_{k=1}^{R} \frac{1}{S} \sum_{i=k}^{k+S-1} C_i)$$

dans laquelle M2 désigne ladite deuxième moyenne, S correspond à la première quantité et $C_i$ correspond audit nombre compté durant une période courante du signal de référence.

Cette formule générale permet de déterminer la deuxième moyenne par exemple de façon logicielle.

Cela étant, lorsque R est égal à une deuxième quantité P de périodes du signal de référence diminuée de la première quantité S et que la première quantité S et la deuxième quantité P sont des puissances de deux, la formule peut s'exprimer de manière plus avantageuse encore et permettre alors une implémentation matérielle simple

Ainsi, lorsque la première quantité S est égale à la moitié de la deuxième quantité P, les étapes a) à e) peuvent être mises en oeuvre par l'application de la formule suivante:

$$M2 = \frac{1}{P-S} * \frac{1}{S} * (\sum_{i=1}^{S} i * C_i + \sum_{i=S+1}^{P-1} (P-i) * C_i)$$

Cette formule permet avantageusement une implémentation matérielle simple du procédé, à base de moyens simples tels qu'un compteur, un compteur à consigne, un accumulateur, etc.

Lorsque la première quantité S est inférieure à $\frac{P}{2}$, les étapes a) à e) peuvent être mises en oeuvres par l'application de la formule suivante:

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

Cette formule permet également une implémentation matérielle simple du procédé, à base de moyens simples tels qu'un compteur, un compteur à consigne légèrement différent du compteur à consigne précédent, un accumulateur, etc.

Selon un autre aspect, il est proposé un dispositif de détermination de la fréquence d'un signal à partir d'un signal périodique de référence, comprenant des moyens de traitement configurés pour effectuer

a) un comptage du nombre de périodes entières dudit signal pendant une première période du signal de référence,
b) une répétition de l'étape a) pour chaque autre période du signal de référence pendant une première durée égale à une première quantité de périodes du signal de référence,
c) une détermination d'une première moyenne desdits nombres,
d) R répétitions d'au moins une partie des étapes a) à c) en décalant à chaque répétition le début du comptage de l'étape a) d'au moins une période du signal de référence, et en prenant éventuellement en compte pour l'étape b) et pour l'étape c) des nombres de périodes entières dudit signal déjà comptés lors d'au moins un groupe précédent d'étapes a) à b),
e) une détermination d'une deuxième moyenne de toutes les premières moyennes ainsi obtenues et
f) une détermination de la fréquence dudit signal à partir de ladite deuxième moyenne et de la fréquence du signal de référence.

Les moyens de traitement sont avantageusement configurés pour effectuer les R répétitions d) des étapes a), b), et c) en parallèle.

Selon un mode de réalisation, les moyens de traitement sont configurés pour mettre en oeuvre les étapes a) à e) par l'application de la formule suivante :

$$M2 = \frac{1}{R} * \left( \sum_{k=1}^{R} \frac{1}{S} \sum_{i=k}^{k+S-1} C_i \right)$$

dans laquelle M2 désigne ladite deuxième moyenne, S correspond à la première quantité, et $C_i$ correspond audit nombre de périodes entières dudit signal compté durant une période courante du signal de référence.

Lorsque la première quantité S est égale à la moitié de la deuxième quantité P, les moyens de traitement sont configurés pour mettre en oeuvre les étapes a) à e) par l'application de la formule suivante :

$$M2 = \frac{1}{P-S} * \frac{1}{S} * \left( \sum_{i=1}^{S} i * C_i + \sum_{i=S+1}^{P-1} (P-i) * C_i \right)$$

Les moyens de traitement peuvent alors comporter :

- un moyen de comptage configuré pour délivrer lesdits nombres successifs,
- un compteur à consigne, configuré pour, au cours des P-1 périodes de référence du signal de référence, s'incrémenter de un à chaque nouvelle période de référence jusqu'à la première quantité puis se décrémenter de un à chaque nouvelle période de référence,
- un multiplieur possédant deux entrées respectivement connectées aux sorties du moyen de comptage et du compteur à consigne,
- un accumulateur connecté en sortie du multiplieur et
- à un moyen de décalage configuré pour effectuer un décalage de bits correspondant à la division par le produit de la première quantité par la différence entre la deuxième quantité et la première quantité.

Ce moyen de décalage peut être réalisé par exemple par un module logiciel.

Lorsque la première quantité est inférieure à la moitié de la deuxième quantité, les moyens de traitements sont configurés pour mettre en oeuvre les étapes a) à e) par l'application de la formule suivante :

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

Ainsi, les moyens de traitement peuvent comprendre :

- un moyen de comptage configuré pour délivrer lesdits nombres successifs,
- un compteur à consigne, configuré pour au cours des P-1 périodes de référence du signal de référence, s'incrémenter de un à chaque nouvelle période de référence jusqu'à la première quantité, puis se maintenir à la première quantité pendant un nombre de périodes de référence égal à la différence entre P-1 et 2S, puis se décrémenter de un à chaque nouvelle période de référence.

- un multiplieur possédant deux entrées respectivement connectées aux sorties du moyen de comptage et du compteur à consigne,
- un accumulateur connecté en sortie du multiplieur et
- un moyen de décalage configuré pour effectuer un décalage de bits correspondant à la division par le produit de la première quantité par la différence entre la deuxième quantité et la première quantité.

Ce moyen de décalage peut également être réalisé par exemple par un module logiciel.

D'autres avantages et caractéristiques de l'invention apparaitront à l'examen de la description détaillée de modes de mise en oeuvre et de réalisation de l'invention, nullement limitatifs, et des dessins annexés sur lesquels

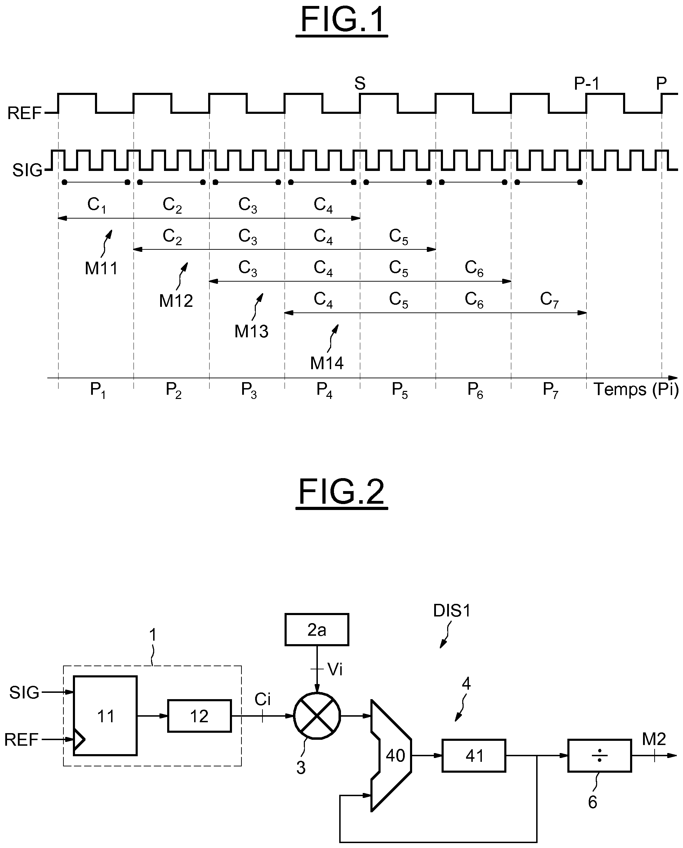

- Les figures 1 à 6 illustrent des modes de mise en oeuvre et de réalisation de l'invention.

La figure 1 illustre un exemple d'un procédé de détermination d'une fréquence d'un signal périodique SIG, à partir d'un signal périodique de référence REF.

Le signal de référence REF peut être par exemple mais non limitativement un signal de référence d'une boucle à verrouillage de phase, et le signal SIG peut être par exemple mais non limitativement le signal délivré par un oscillateur commandé en tension faisant partie de cette même boucle à verrouillage de phase.

Dans la suite de la description, l'indice i sera utilisé pour représenter les différents éléments associés à une période $P_i$ du signal de référence. Ainsi, un indice 1 est associé à la période $P_1$, un indice 2 à la période $P_2$, etc.

Lors d'une première étape a) du procédé, on réalise un comptage d'un nombre $C_i$ de périodes entières du premier signal SIG durant une première période de référence $P_1$ du signal de référence REF.

On répète (étape b)) le comptage a) pour chaque autre période successive $P_i$ du signal de référence REF, durant une première quantité S de périodes de référence $P_i$.

Dans cet exemple S=4. On réalise donc les comptages successifs des nombres $C_1$, $C_2$, $C_3$ et $C_4$ de périodes entières du premier signal SIG ayant lieu durant les périodes successives $P_1$, $P_2$, $P_3$ et $P_4$.

On réalise ensuite (étape c)) une première moyenne M11 des différents nombres $C_i$ comptés durant les quatre répétitions de la première étape a). Dans cette exemple, la première moyenne M11 sera égale à la somme des nombre $C_1$, $C_2$, $C_3$, et $C_4$, divisée par la première quantité S=4.

On répète les étapes a) à c), une quantité de fois égale à la différence entre une deuxième quantité P de périodes de référence et la première quantité S=4, en décalant le début du comptage d'une période de référence $P_i$ à chaque répétition.

Dans cet exemple, P=8. On réalise donc parallèlement P-S=4 premières moyennes M11, M12, M13, et M14 portant chacune sur 4 nombres $C_i$ successifs.

M11 est donc la moyenne des nombres $C_1$ à $C_4$, M12 la moyenne des nombre $C_2$ à $C_5$, M13 la moyenne des nombre $C_3$ à $C_6$, et M14 la moyenne des nombre $C_3$ à $C_7$.

Enfin, on réalise une deuxième moyenne M2 sur les valeurs des premières moyennes M11, M12, M13, et M14

Ici, la valeur de la deuxième moyenne M2 est donc égale à la somme des premières moyennes M11, M12, M13, et M14, divisée par P-S=4.

Afin d'obtenir la fréquence du premier signal, on multiplie ensuite la fréquence du signal de référence par la valeur de la deuxième moyenne M2.

Le procédé ainsi effectué est équivalent à l'application de la première formule F1 suivante:

$$M2 = \frac{1}{P-S} * \left( \sum_{k=1}^{P-S} \frac{1}{S} \sum_{i=k}^{k+S-1} C_i \right) \qquad (F1)$$

Cette formule pourrait être mise en oeuvre de façon logicielle au sein d'un microcontrôleur par exemple.

Cela étant, les inventeurs ont observé qu'en choisissant la première quantité S et la deuxième quantité P comme étant des puissances de deux et particulièrement en choisissant $S = \frac{P}{2}$, le procédé est équivalent à l'application de la deuxième formule F2 suivante :

$$M2 = \frac{1}{P-S} * \frac{1}{S} * \left( \sum_{i=1}^{S} i * C_i + \sum_{i=S+1}^{P-1} (P-i) * C_i \right) \qquad (F2)$$

Cette formule est particulièrement avantageuse car elle permet non seulement d'appliquer la formule avec des moyens logiciels, mais aussi avec des moyens matériels simples tels que ceux du dispositif DIS1 illustré à la figure 2.

Il est alors également possible de ne pas répéter à chaque répétition le comptage de certains nombres $C_i$ et de conserver ces nombres Ci pour ensuite les pondérer.

Le dispositif DIS1 de la figure 2 comprend ici un moyen de comptage 1, recevant en entrée le signal de référence REF et le premier signal SIG. Le moyen de comptage 1 est configuré pour compter chaque nombre $C_i$ de périodes entières du premier signal SIG ayant lieu durant chaque période de référence $P_i$.

Dans cet exemple, le moyen de comptage 1 comprend un compteur 11 cadencé par le signal REF associé à un décodeur 12.

Le compteur 11 est configuré pour s'incrémenter à chaque période du signal SIG, et le décodeur 12 est configuré pour remettre le compteur 11 à zéro à chaque période de référence $P_i$.

Le dispositif DIS1 comprend également un compteur à consigne 2a configuré pour délivrer une valeur de compteur $V_i$ à chaque période de référence $P_i$ du signal de référence.

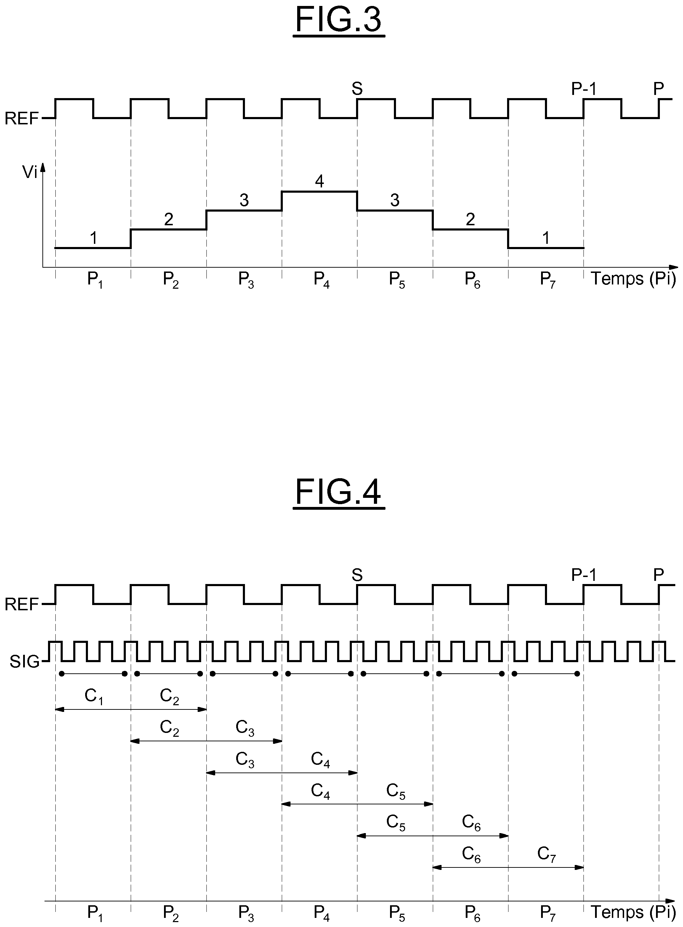

Comme illustré sur la figure 3, le compteur 2a est dans cet exemple configuré pour, au cours des P-1=7 périodes de référence $P_1$ à $P_7$, s'incrémenter de un à chaque nouvelle période de référence $P_i$ jusqu'à la première quantité S=4 puis se décrémenter de un à chaque nouvelle période de référence $P_i$.

Ainsi, la valeur $V_i$ du compteur à consigne sera successivement égale à 1, 2, 3, 4, 3, 2, 1 respectivement durant les périodes de référence $P_1$, $P_2$, $P_3$, $P_4$, $P_5$, $P_6$, $P_7$.

Les sorties du moyen de comptage 1 et du compteur à consigne 2a sont toutes les deux connectées à un multiplieur 3 (figure 2). Ainsi, chaque nombre successif $C_i$ est multiplié par la valeur de compteur associée Vi.

Un accumulateur 4 comporte un additionneur asynchrone 40 et un registre 41 pour synchroniser les sommes à effectuer. Une première entrée de l'additionneur est connectée en sortie du multiplieur 3 de manière à recevoir chaque nombre $C_i$ multiplié par sa valeur de compteur associée Vi. La sortie du registre 41 est rebouclée sur une deuxième entrée de l'additionneur. Initialement, l'accumulateur 4 contient une valeur nulle.

A chaque période de référence $P_i$, l'accumulateur stocke la valeur de sortie du multiplieur et l'additionne avec la valeur précédemment stockée. La somme des valeurs stockées est retournée sur la deuxième entrée de l'additionneur 40 et synchronisée par le registre 41.

La somme finalement stockée est donc égale à

$$C_1 + 2*C_2 + 3*C_1 + 4*C_4 + 3*C_5 + 2*C_6 + C_7$$

Le dispositif comprend en outre un moyen de décalage 6, par exemple un module logiciel, configuré pour effectuer un décalage de bits sur la valeur binaire de la somme stockée et délivrer la deuxième moyenne M2.

Dans cet exemple, le décalage de bits correspond à une division par le produit (P-S)*S = 16, soit un décalage de 4 bits vers la droite.

Il convient de noter que la division ainsi effectuée par un décalage de bits est possible grâce au choix de puissances de 2 pour la première quantité S et la deuxième quantité P.

Ainsi il est possible, pour un signal de référence de 16MHZ, d'obtenir une précision de 62,5KHz dans un nombre de périodes du signal de référence égal à 32, alors que 256 périodes du signal de référence auraient été nécessaires avec un compteur classique.

Selon un autre mode de mise en oeuvre illustré sur les figures 4 à 6, on a choisi S inférieur à $\frac{P}{2}$, par exemple S=2 et P=8.

On réalise donc les comptages successifs des nombres $C_i$ de périodes entières du signal SIG ayant lieu durant deux périodes $P_i$ successives.

On réalise ensuite la moyenne M11 des deux nombres $C_1$ et $C_2$ comptés durant les deux périodes de référence $P_1$ et $P_2$.

On répète cette étape de procédé, une quantité de fois égale P-S=6, en décalant le début du comptage d'une période de référence $P_i$ à chaque répétition.

On réalise donc parallèlement 6 moyennes M11, M12, M13, M14, M15 et M16, portant chacune sur 2 nombres $C_i$ successifs.

Enfin, on réalise une deuxième moyenne M2 sur les valeurs des premières moyennes M11, M12, M13, M14, M15 et M16.

Les inventeurs ont remarqué qu'en choisissant $S < \frac{P}{2}$, avec P et S des puissances de deux, la formule F1 ci-avant est équivalente à la formule F3 suivante :

$$M2 = \frac{1}{P-S} * \frac{1}{S} * \left( \sum_{i=1}^{S} i*C_i + \sum_{i=S+1}^{P-S} S*C_i + \sum_{i=P-S+1}^{P-1} (P-i)*C_i \right) \qquad (F3)$$

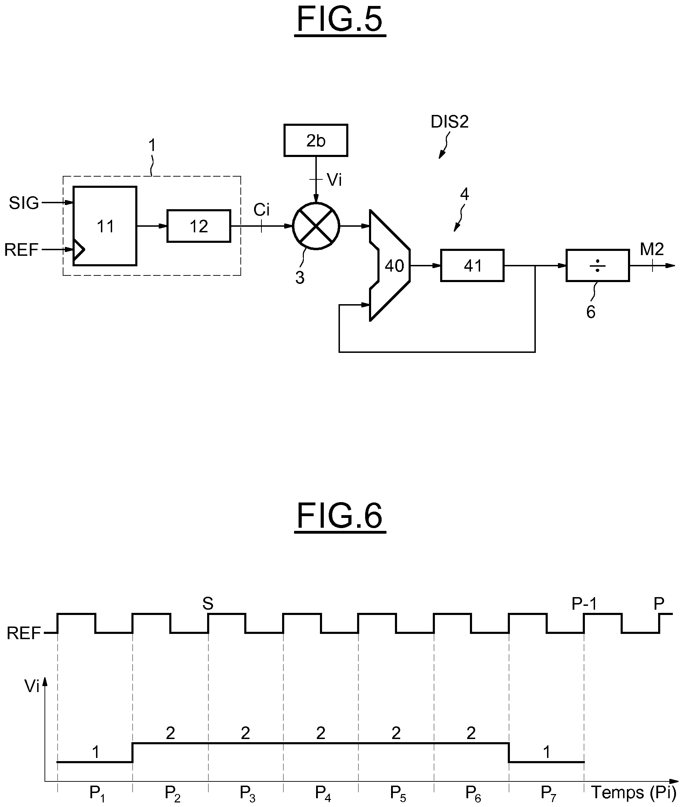

Cette formule permet d'appliquer ce procédé avec des moyens logiciels, mais également là encore avec des moyens matériels simples tels que le dispositif DIS2 illustré à la figure 5 tout en évitant des comptages répétitifs de certains nombres $C_i$.

Ce dispositif DIS2 est similaire au dispositif DIS1 illustré sur la figure 2 et décrit précédemment, mais diffère en ce qu'il comprend un compteur consigne 2b configuré différemment.

La figure 6 illustre un fonctionnement possible du compteur à consigne 2b dans le cas où P=8 et S=2.

Le compteur est ici configuré pour s'incrémenter à la deuxième période de référence $P_2$, puis pour se maintenir durant cinq périodes de référence $P_2$ à $P_6$ à une valeur égale à deux, puis pour se décrémenter une fois durant la période de référence $P_7$.

Ainsi, la somme finalement stockée par l'accumulateur est donc

$$C_1 + 2 * C_2 + 2 * C_1 + 2 * C_4 + 2 * C_5 + 2 * C_6 + C_7$$

Dans ce mode de réalisation également, la division comporte là encore un décalage de bits sur la valeur de l'accumulateur, et cela est possible grâce au choix de puissances de deux pour la première quantité S et la deuxième quantité P.

Bien qu'il ait été décrit ici des modes de mise en oeuvre et de réalisation de l'invention dans lesquels la deuxième quantité P est 8 et la première quantité S est 2 ou 4, l'invention est compatible avec toute autre première quantité et toute autre deuxième quantité, que ces deux quantités soient ou non des puissances de deux, pour autant que S soit inférieur à P. Le fait que S et P soient des puissances de deux permet d'obtenir une réalisation intégré particulièrement compacte et de réaliser la division par S(P-S) par un simple décalage de bits.

## Revendications

1. Procédé de détermination de la fréquence d'un signal (SIG) à partir d'un signal périodique de référence (REF), comprenant

   a) un comptage du nombre ($C_i$) de périodes entières dudit signal (SIG) pendant une première période du signal de référence,
   b) une répétition de l'étape a) pour chaque période ($P_i$) du signal de référence (REF) jusqu'à l'expiration d'une première durée égale à une première quantité (S) de périodes du signal de référence, et
   c) une détermination d'une première moyenne (M1) desdits nombres ($C_i$),
   d) R répétitions d'au moins une partie des étapes a) à c), en décalant à chaque répétition le début du comptage de l'étape a) d'au moins une période ($P_i$) du signal de référence, en prenant éventuellement en compte pour l'étape b) et pour l'étape c) des nombres de périodes entières dudit signal déjà comptés lors d'au moins un groupe précédent d'étapes a) à b),
   e) une détermination d'une deuxième moyenne (M2) de toutes les premières moyennes (M1) ainsi obtenues, et
   f) une détermination de la fréquence dudit signal (SIG) à partir de ladite deuxième moyenne (M2) et de la fréquence du signal de référence (REF).

2. Procédé selon la revendication 1, dans lequel les R répétitions des étapes a), b) et c) sont effectuées en parallèle.

3. Procédé selon l'une des revendications précédentes, dans lequel les étapes a) à e) sont mises en oeuvre par l'application de la formule suivante :

$$M2 = \frac{1}{R} * \left( \sum_{k=1}^{R} \frac{1}{S} \sum_{i=k}^{k+S-1} C_i \right)$$

dans laquelle M2 désigne ladite deuxième moyenne, S correspond à la première quantité, et $C_i$ correspond audit nombre de périodes entières dudit signal compté durant une période courante du signal de référence.

4. Procédé selon l'une des revendications 1 ou 2, dans lequel R est égal à une deuxième quantité (P) de périodes du signal de référence diminuée de la première quantité (S).

5. Procédé selon la revendication 4, dans lequel la première quantité (S) et la deuxième quantité (P) sont des puissances de deux.

**6.** Procédé selon la revendication 5, dans lequel la première quantité (S) est égale à la moitié de la deuxième quantité (P).

**7.** Procédé selon la revendication 6, dans lequel les étapes a) à e) sont mises en oeuvre par l'application de la formule suivante :

$$M2 = \frac{1}{P-S} * \frac{1}{S} * \left( \sum_{i=1}^{S} i * C_i + \sum_{i=S+1}^{P-1} (P-i) * C_i \right)$$

dans laquelle M2 désigne ladite deuxième moyenne, S correspond à la première quantité, P correspond à la deuxième quantité et $C_i$ correspond audit nombre de périodes entières dudit signal compté durant une période courante du signal de référence.

**8.** Procédé selon la revendication 5, dans lequel la première quantité (S) est inférieure à la moitié de la deuxième quantité (P).

**9.** Procédé selon la revendication 8, dans lequel les étapes a) à e) sont mises en oeuvre par l'application de la formule suivante :

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

dans laquelle M2 désigne ladite deuxième moyenne, S correspond à la première quantité, P correspond à deuxième quantité, et $C_i$ correspond audit nombre de périodes entières dudit signal compté durant une période courante du signal de référence.

**10.** Procédé de détermination de la fréquence d'un signal (SIG) à partir d'un signal périodique de référence (REF), comprenant

- une détermination d'une moyenne M2 obtenue par la formule suivante

$$M2 = \frac{1}{P-S} * \frac{1}{S} * \left( \sum_{i=1}^{S} i * C_i + \sum_{i=S+1}^{P-1} (P-i) * C_i \right)$$

dans laquelle S est une première quantité de périodes du signal de référence, P une deuxième quantité de périodes du signal de référence, P et S étant des puissances de deux avec S égal à P/2, et $C_i$ correspond au nombre de périodes entières dudit signal (SIG) compté durant une période courante du signal de référence, et
- une détermination de la fréquence dudit signal (SIG) à partir de ladite moyenne M2 et de la fréquence du signal de référence (REF).

**11.** Procédé de détermination de la fréquence d'un signal (SIG) à partir d'un signal périodique de référence (REF), comprenant

- une détermination d'une moyenne M2 obtenue par la formule suivante

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

dans laquelle S est une première quantité de périodes du signal de référence, P une deuxième quantité de périodes du signal de référence, P et S étant des puissances de deux avec S inférieur à P/2, et $C_i$ correspond au nombre de périodes entières dudit signal (SIG) compté durant une période courante du signal de référence, et

- une détermination de la fréquence dudit signal (SIG) à partir de ladite moyenne M2 et de la fréquence du signal de référence (REF).

**12.** Dispositif (DIS) de détermination de la fréquence d'un signal (SIG) à partir d'un signal périodique de référence (REF), comprenant des moyens de traitement configurés pour effectuer

a) un comptage du nombre ($C_i$) de périodes entières dudit signal (SIG) pendant une première période (Pi) du signal de référence (REF),
b) R répétitions de l'étape a) pour chaque autre période (Pi) du signal de référence (REF) pendant une première durée égale à une première quantité (S) de périodes (Pi) du signal de référence (REF),
c) une détermination d'une première moyenne (M1) desdits nombres ($C_i$),
d) R répétitions d'au moins une partie des étapes a) à c), en décalant à chaque répétition le début du comptage de l'étape a) d'au moins une période (Pi) du signal de référence, en prenant éventuellement en compte pour l'étape b) et pour l'étape c) des nombres de périodes entières dudit signal déjà comptés lors d'au moins un groupe précédent d'étapes a) à b),
e) une détermination d'une deuxième moyenne (M2) de toutes les premières moyennes (M1) ainsi obtenues et
f) une détermination de la fréquence dudit signal (SIG) à partir de ladite deuxième moyenne (M2) et de la fréquence du signal de référence (REF).

**13.** Dispositif selon la revendication 12, dans lequel les moyens de traitement sont configurés pour effectuer en parallèle les R répétitions des étapes a), b) et c).

**14.** Dispositif selon l'une des revendications 12 ou 13, dans lequel les moyens de traitement sont configurés pour mettre en oeuvre les étapes a) à e) par l'application de la formule suivante :

$$M2 = \frac{1}{R} * \left( \sum_{k=1}^{R} \frac{1}{S} \sum_{i=k}^{k+S-1} C_i \right)$$

dans laquelle M2 correspond à la deuxième moyenne, S correspond à la première quantité et $C_i$ correspond audit nombre de périodes entières dudit signal compté durant une période courante du signal de référence.

**15.** Dispositif selon l'une des revendications 12 ou 13, dans lequel R est égal à une deuxième quantité (P) de période (Pi) du signal de référence (REF) diminuée de la première quantité (S).

**16.** Dispositif selon la revendication 15, dans lequel la première quantité (S) et la deuxième quantité (P) sont des puissances de deux.

**17.** Dispositif selon la revendication 16, dans lequel la première quantité (S) est la moitié de la deuxième quantité (P) et les moyens de traitement sont configurés pour mettre en oeuvre les étape a) à e) par l'application de la formule suivante :

$$M2 = \frac{1}{P-S} * \frac{1}{S} * \left( \sum_{i=1}^{S} i * C_i + \sum_{i=S+1}^{P-1} (P-i) * C_i \right)$$

dans laquelle M2 correspond à la deuxième moyenne, S correspond à la première quantité, P correspond à la deuxième quantité, $C_i$ correspond audit nombre de périodes entières dudit signal compté durant une période courante du signal de référence.

**18.** Dispositif de détermination de la fréquence d'un signal (SIG) à partir d'un signal périodique de référence (REF), comprenant des moyens de traitement configurés pour

- déterminer une moyenne M2 obtenue par la formule suivante

$$M2 = \frac{1}{P-S} * \frac{1}{S} * (\sum_{i=1}^{S} i * C_i + \sum_{i=S+1}^{P-1} (P-i) * C_i)$$

dans laquelle S est une première quantité de périodes du signal de référence, P une deuxième quantité de périodes du signal de référence, P et S étant des puissance de deux avec S égal à P/2, et $C_i$ correspond au nombre de périodes entières dudit signal (SIG) compté durant une période courante du signal de référence, et
- déterminer la fréquence dudit signal (SIG) à partir de ladite moyenne M2 et de la fréquence du signal de référence (REF).

**19.** Dispositif selon la revendication 17 ou 18, dans lequel les moyens de traitement comportent

- un moyen de comptage (1) configuré pour délivrer lesdits nombres ($C_i$) successifs de périodes entières dudit signal,
- un compteur à consigne (2a), configuré pour, au cours des P-1 périodes de référence ($P_i$) du signal de référence, s'incrémenter de un à chaque nouvelle période de référence ($P_i$) jusqu'à la première quantité (S) puis se décrémenter de un à chaque nouvelle période de référence ($P_i$),
- un multiplieur (3) possédant deux entrées respectivement connectées aux sorties du moyen de comptage (1) et du compteur à consigne (2),
- un accumulateur (4) connecté en sortie du multiplieur (3) et
- un moyen de décalage (6) connecté à la sortie de l'accumulateur (4) et configuré pour effectuer un décalage de bits correspondant à la division par le produit de S par P-S.

**20.** Dispositif selon la revendication 16, dans lequel la première quantité (S) est inférieure à la moitié de la deuxième quantité (8) et les moyens de traitement sont configurés pour mettre en oeuvre les étapes a) à e) par l'application de la formule suivante :

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

dans laquelle M2 correspond à la deuxième moyenne, S correspond à la première quantité, P correspond à la deuxième quantité, $C_i$ correspond audit nombre de périodes entière dudit signal compté durant une période courante du signal de référence.

**21.** Dispositif de détermination de la fréquence d'un signal (SIG) à partir d'un signal périodique de référence (REF), comprenant des moyens de traitement configurés pour

- déterminer une moyenne M2 obtenue par la formule suivante :

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

dans laquelle S est une première quantité de périodes du signal de référence, P une deuxième quantité de périodes du signal de référence, P et S étant des puissance de deux avec S inférieur à $\frac{P}{2}$, et $C_i$ correspond au nombre de périodes entières dudit signal (SIG) compté durant une période courante du signal de référence, et
- déterminer la fréquence dudit signal (SIG) à partir de ladite moyenne M2 et de la fréquence du signal de référence (REF)

**22.** Dispositif selon la revendication 20 ou 21, dans lequel les moyens de traitement comportent

- un moyen de comptage (1) configuré pour délivrer lesdits nombres ($C_i$) successifs,

- un compteur à consigne (2b), configuré pour au cours des P-1 périodes de référence (P$_i$) du signal de référence, s'incrémenter de un à chaque nouvelle période de référence (P$_i$) jusqu'à la première quantité (S), puis se maintenir à la première quantité (S) pendant un nombre de périodes de référence égal à la différence entre P-1 et 2S, puis se décrémenter de un à chaque nouvelle période de référence (P$_i$).

- un multiplieur (3) possédant deux entrées respectivement connectées aux sorties du moyen de comptage (1) et du compteur à consigne (2),

- un accumulateur (4) connecté en sortie du multiplieur (3) et

- un moyen de décalage (6) connecté à la sortie de l'accumulateur (4) et configuré pour effectuer un décalage de bits correspondant à la division par le produit de S par P-S.

**Patentansprüche**

1. Verfahren zur Bestimmung der Frequenz eines Signals (SIG) auf Basis eines periodischen Referenzsignals (REF), umfassend:

   a) ein Zählen der Anzahl (C$_i$) von ganzen Perioden des Signals (SIG) während einer ersten Periode des Referenzsignals,
   b) eine Wiederholung des Schrittes a) für jede Periode (Pi) des Referenzsignals (REF) bis zum Ablauf einer ersten Dauer gleich einer ersten Menge (S) an Perioden des Referenzsignals, und
   c) eine Bestimmung eines ersten Durchschnitts (M1) der Anzahlen (C$_i$),
   d) R Wiederholungen mindestens eines Teils der Schritte a) bis c), wobei bei jeder Wiederholung der Beginn des Zählens des Schrittes a) um mindestens eine Periode (P$_i$) des Referenzsignals versetzt wird, wobei eventuell für den Schritt b) und für den Schritt c) Anzahlen von ganzen Perioden des Signals berücksichtigt werden, die bereits bei mindestens einer vorhergehenden Gruppe von Schritten a) bis b) gezählt wurden,
   e) eine Bestimmung eines zweiten Durchschnitts (M2) aller ersten so erhaltenen Durchschnitte (M1), und
   f) eine Bestimmung der Frequenz des Signals (SIG) auf Basis des zweiten Durchschnitts (M2) und der Frequenz des Referenzsignals (REF).

2. Verfahren nach Anspruch 1, bei dem die R Wiederholungen der Schritte a), b) und c) parallel erfolgen.

3. Verfahren nach einem der vorhergehenden Ansprüche, bei dem die Schritte a) bis e) durch Anwendung der folgenden Formel eingesetzt werden:

$$M2 = \frac{1}{R} * \left( \sum_{k=1}^{R} \frac{1}{S} \sum_{i=k}^{k+S-1} C_i \right)$$

wobei M2 dem zweiten Durchschnitt entspricht, S der ersten Menge entspricht, und C$_i$ der Anzahl von ganzen Perioden des gezählten Signals während einer laufenden Periode des Referenzsignals entspricht.

4. Verfahren nach einem der Ansprüche 1 oder 2, bei dem R gleich einer zweiten Menge (P) von Perioden des Referenzsignals, verringert um die erste Menge (S) ist.

5. Verfahren nach Anspruch 4, bei dem die erste Menge (S) und die zweite Menge (P) Leistungen von zwei sind.

6. Verfahren nach Anspruch 5, bei dem die erste Menge (S) gleich der Hälfte der zweiten Menge (P) ist.

7. Verfahren nach Anspruch 6, bei dem die Schritte a) bis e) durch Anwendung der folgenden Formel eingesetzt werden:

$$M2 = \frac{1}{P-S} * \frac{1}{S} * \left( \sum_{i=1}^{S} i * C_i + \sum_{i=S+1}^{P-1} (P-i) * C_i \right)$$

wobei M2 dem zweiten Durchschnitt entspricht, S der ersten Menge entspricht, P der zweiten Menge entspricht und C$_i$ der Anzahl von ganzen Perioden des gezählten Signals während einer laufenden Periode des Referenzsignals entspricht.

8. Verfahren nach Anspruch 5, bei dem die erste Menge (S) kleiner als die Hälfte der zweiten Menge (P) ist.

9. Verfahren nach Anspruch 8, bei dem die Schritte a) bis e) durch Anwendung der folgenden Formel eingesetzt werden:

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

wobei M2 dem zweiten Durchschnitt entspricht, S der ersten Menge entspricht, P der zweiten Menge entspricht und $C_i$ der Anzahl von ganzen Perioden des gezählten Signals während einer laufenden Periode des Referenzsignals entspricht.

10. Verfahren zur Bestimmung der Frequenz eines Signals (SIG) auf Basis eines periodischen Referenzsignals (REF), umfassend:

- eine Bestimmung eines Durchschnitts M2, der durch folgende Formel erhalten wird:

$$M2 = \frac{1}{P-S} * \frac{1}{S} * (\sum_{i=1}^{S} i * C_i + \sum_{i=S+1}^{P-1} (P-i) * C_i)$$

wobei S eine erste Menge von Perioden des Referenzsignals ist, P eine zweite Menge von Perioden des Referenzsignals ist, wobei P und S Leistungen von zwei mit S gleich P/2 sind, und wobei $C_i$ der Anzahl von ganzen Perioden des gezählten Signals (SIG) während einer laufenden Periode des Referenzsignals entspricht, und
- eine Bestimmung der Frequenz des Signals (SIG) auf Basis des Durchschnitts M2 und der Frequenz des Referenzsignals (REF).

11. Verfahren zur Bestimmung der Frequenz eines Signals (SIG) auf Basis eines periodischen Referenzsignals (REF), umfassend:

- eine Bestimmung eines Durchschnitts M2, der durch folgende Formel erhalten wird:

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

wobei S eine erste Menge von Perioden des Referenzsignals ist, P eine zweite Menge von Perioden des Referenzsignals ist, wobei P und S Leistungen von zwei mit S kleiner als P/2 sind, und wobei $C_i$ der Anzahl von ganzen Perioden des gezählten Signals (SIG) während einer laufenden Periode des Referenzsignals entspricht, und
- eine Bestimmung der Frequenz des Signals (SIG) auf Basis des Durchschnitts M2 und der Frequenz des Referenzsignals (REF).

12. Vorrichtung (DIS) zur Bestimmung der Frequenz eines Signals (SIG) auf Basis eines periodischen Referenzsignals (REF), umfassend Bearbeitungsmittel, die eingerichtet sind, um auszuführen:

a) ein Zählen der Anzahl ($C_i$) von ganzen Perioden des Signals (SIG) während einer ersten Periode (Pi) des Referenzsignals (REF),
b) R Wiederholungen des Schrittes a) für jede weitere Periode ($P_i$) des Referenzsignals (REF) während einer ersten Dauer gleich einer ersten Menge (S) an Perioden ($P_i$) des Referenzsignals (REF), und
c) eine Bestimmung eines ersten Durchschnitts (M1) der Anzahlen ($C_i$),
d) R Wiederholungen mindestens eines Teils der Schritte a) bis c), wobei bei jeder Wiederholung der Beginn des Zählens des Schrittes a) um mindestens eine Periode (Pi) des Referenzsignals versetzt wird, wobei eventuell für den Schritt b) und für den Schritt c) Anzahlen von ganzen Perioden des Signals berücksichtigt werden, die bereits bei mindestens einer vorhergehenden Gruppe von Schritten a) bis b) gezählt wurden,

e) eine Bestimmung eines zweiten Durchschnitts (M2) aller ersten so erhaltenen Durchschnitte (M1), und

f) eine Bestimmung der Frequenz des Signals (SIG) auf Basis des zweiten Durchschnitts (M2) und der Frequenz des Referenzsignals (REF).

**13.** Vorrichtung nach Anspruch 12, bei der die Bearbeitungsmittel eingerichtet sind, um die R Wiederholungen der Schritte a), b) und c) parallel durchzuführen.

**14.** Vorrichtung nach einem der Ansprüche 12 oder 13, bei der die Bearbeitungsmittel eingerichtet sind, um die Schritte a) bis e) durch Anwendung der folgenden Formel einzusetzen:

$$M2 = \frac{1}{R} * \left(\sum_{k=1}^{R} \frac{1}{S} \sum_{i=k}^{k+S-1} C_i\right)$$

wobei M2 dem zweiten Durchschnitt entspricht, S der ersten Menge entspricht, und $C_i$ der Anzahl von ganzen Perioden des gezählten Signals während einer laufenden Periode des Referenzsignals entspricht.

**15.** Vorrichtung nach einem der Ansprüche 12 oder 13, bei der R gleich einer zweiten Menge (P) einer Periode (Pi) des Referenzsignals (REF), verringert um die erste Menge (S), ist.

**16.** Vorrichtung nach Anspruch 15, bei der die erste Menge (S) und die zweite Menge (P) Leistungen von zwei sind.

**17.** Vorrichtung nach Anspruch 16, bei der die erste Menge (S) gleich der Hälfte der zweiten Menge (P) ist, und die Bearbeitungsmittel eingerichtet sind, um die Schritte a) bis e) durch Anwendung der folgenden Formel einzusetzen:

$$M2 = \frac{1}{P-S} * \frac{1}{S} * \left(\sum_{i=1}^{S} i * C_i + \sum_{i=S+1}^{P-1} (P-i) * C_i\right)$$

wobei M2 dem zweiten Durchschnitt entspricht, S der ersten Menge entspricht, P der zweiten Menge entspricht und $C_i$ der Anzahl von ganzen Perioden des gezählten Signals während einer laufenden Periode des Referenzsignals entspricht.

**18.** Vorrichtung zur Bestimmung der Frequenz eines Signals (SIG) auf Basis eines periodischen Referenzsignals (REF), umfassend Bearbeitungsmittel, die eingerichtet sind, um auszuführen:

- eine Bestimmung eines Durchschnitts M2, der durch folgende Formel erhalten wird:

$$M2 = \frac{1}{P-S} * \frac{1}{S} * \left(\sum_{i=1}^{S} i * C_i + \sum_{i=S+1}^{P-1} (P-i) * C_i\right)$$

wobei S eine erste Menge von Perioden des Referenzsignals ist, P eine zweite Menge von Perioden des Referenzsignals ist, wobei P und S Leistungen von zwei mit S gleich P/2 sind, und wobei $C_i$ der Anzahl von ganzen Perioden des gezählten Signals (SIG) während einer laufenden Periode des Referenzsignals entspricht, und

- eine Bestimmung der Frequenz des Signals (SIG) auf Basis des Durchschnitts M2 und der Frequenz des Referenzsignals (REF).

**19.** Vorrichtung nach Anspruch 17 oder 18, bei der die Bearbeitungsmittel umfassen:

- ein Zählmittel (1), das eingerichtet ist, um die aufeinanderfolgenden Anzahlen ($C_i$) von ganzen Perioden des Signals zu liefern,

- einen Sollwertzähler (2a), der eingerichtet ist, um sich während der P-1 Referenzperioden (Pi) des Referenzsignals von eins bei jeder neuen Referenzperiode (Pi) bis zur ersten Menge (S) zu inkrementieren, und sich dann von eins bei jeder neuen Referenzperiode (Pi) zu dekrementieren,
- einen Multiplizierer (3), der zwei Eingänge besitzt, die jeweils an die zwei Ausgänge des Zählmittels (1) und des Sollwertzählers (2) angeschlossen sind,
- einen Akkumulator (4), der an den Ausgang des Multiplizierers (3) angeschlossen ist, und
- ein Versatzmittel (6), das an den Ausgang des Akkumulators (4) angeschlossen und eingerichtet ist, um einen Versatz von Bits entsprechend der Division durch das Produkt von S durch P-S durchzuführen.

20. Vorrichtung nach Anspruch 16, bei der die erste Menge (S) kleiner als die Hälfte der zweiten Menge (8) ist, und die Bearbeitungsmittel eingerichtet sind, um die Schritte a) bis e) durch Anwendung der folgenden Formel einzusetzen:

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

wobei M2 dem zweiten Durchschnitt entspricht, S der ersten Menge entspricht, P der zweiten Menge entspricht und $C_i$ der Anzahl von ganzen Perioden des gezählten Signals während einer laufenden Periode des Referenzsignals entspricht.

21. Vorrichtung zur Bestimmung der Frequenz eines Signals (SIG) auf Basis eines periodischen Referenzsignals (REF), umfassend Bearbeitungsmittel, die eingerichtet sind, um auszuführen:

- eine Bestimmung eines Durchschnitts M2, der durch folgende Formel erhalten wird:

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

wobei S eine erste Menge von Perioden des Referenzsignals ist, P eine zweite Menge von Perioden des Referenzsignals ist, wobei P und S Leistungen von zwei mit S kleiner als P/2 sind, und wobei $C_i$ der Anzahl von ganzen Perioden des gezählten Signals (SIG) während einer laufenden Periode des Referenzsignals entspricht, und
- eine Bestimmung der Frequenz des Signals (SIG) auf Basis des Durchschnitts M2 und der Frequenz des Referenzsignals (REF).

22. Vorrichtung nach Anspruch 20 oder 21, bei der die Bearbeitungsmittel umfassen:

- ein Zählmittel (1), das eingerichtet ist, um die aufeinanderfolgenden Anzahlen ($C_i$) zu liefern,
- einen Sollwertzähler (2b), der eingerichtet ist, um sich während der P-1 Referenzperioden (Pi) des Referenzsignals von eins bei jeder neuen Referenzperiode (Pi) bis zur ersten Menge (S) zu inkrementieren, sich dann auf der ersten Menge (S) während einer Anzahl von Referenzperioden gleich der Differenz zwischen P-1 und 2S zu halten, und sich dann von eins bei jeder neuen Referenzperiode (Pi) zu dekrementieren,
- einen Multiplizierer (3), der zwei Eingänge besitzt, die jeweils an die zwei Ausgänge des Zählmittels (1) und des Sollwertzählers (2) angeschlossen sind,
- einen Akkumulator (4), der an den Ausgang des Multiplizierers (3) angeschlossen ist, und
- ein Versatzmittel (6), das an den Ausgang des Akkumulators (4) angeschlossen und eingerichtet ist, um einen Versatz von Bits entsprechend der Division durch das Produkt von S durch P-S durchzuführen.

**Claims**

1. Method for determining the frequency of a signal (SIG) from a periodic reference signal (REF), including

a) a count of the number ($C_i$) of whole periods of said signal (SIG) during a first period of the reference signal,

b) a repetition of step a) for each period (P$_i$) of the reference signal (REF) until the expiry of a first duration equal to a first quantity (S) of periods of the reference signal, and

c) a determination of a first average (M1) of said numbers (C$_i$),

d) R repetitions of at least one part of steps a) to c), at each repetition shifting the start of counting of step a) by at least one period (P$_i$) of the reference signal, optionally taking into account for step b) and step c) the numbers of whole periods of said signal already counted during the at least one preceding group of steps a) and b),

e) a determination of a second average (M2) of all the first averages (M1) thus obtained, and

f) a determination of the frequency of said signal (SIG) from said second average (M2) and the frequency of the reference signal (REF).

2. Method according to Claim 1, in which the R repetitions of steps a), b) and c) are performed in parallel.

3. Method according to one of the preceding claims, in which steps a) to e) are implemented by applying the following formula:

$$M2 = \frac{1}{R} * \left( \sum_{k=1}^{R} \frac{1}{S} \sum_{i=k}^{k+S-1} C_i \right)$$

in which M2 designates said second average, S corresponds to the first quantity and C$_i$ corresponds to said number of whole periods of said signal counted during a current period of the reference signal.

4. Method according to one of Claims 1 and 2, in which R is equal to a second quantity (P) of periods of the reference signal reduced by the first quantity (S).

5. Method according to Claim 4, in which the first quantity (S) and the second quantity (P) are powers of two.

6. Method according to Claim 5, in which the first quantity (S) is equal to half the second quantity (P).

7. Method according to Claim 6, in which steps a) to e) are implemented by applying the following formula:

$$M2 = \frac{1}{P-S} * \frac{1}{S} * \left( \sum_{i=1}^{S} i * C_i + \sum_{i=S+1}^{P-1} (P-i) * C_i \right)$$

in which M2 designates said second average, S corresponds to the first quantity, P corresponds to the second quantity and C$_i$ corresponds to said number of whole periods of said signal counted during a current period of the reference signal.

8. Method according to Claim 5, in which the first quantity (S) is less than half the second quantity (P).

9. Method according to Claim 8, in which steps a) to e) are implemented by applying the following formula:

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

in which M2 designates said second average, S corresponds to the first quantity, P corresponds to the second quantity and C$_i$ corresponds to said number of whole periods of said signal counted during a current period of the reference signal.

10. Method for determining the frequency of a signal (SIG) from a periodic reference signal (REF), including

- a determination of an average M2 obtained by the following formula

$$M2 = \frac{1}{P-S} * \frac{1}{S} * (\sum_{i=1}^{S} i * C_i + \sum_{i=S+1}^{P-1} (P-i) * C_i)$$

in which S is a first quantity of periods of the reference signal, P a second quantity of periods of the reference signal, P and S being powers of two with S equal to P/2, and $C_i$ corresponds to the number of whole periods of said signal (SIG) counted during a current period of the reference signal, and
- a determination of the frequency of said signal (SIG) from said average M2 and the frequency of the reference signal (REF).

11. Method for determining the frequency of a signal (SIG) from a periodic reference signal (REF), including

- a determination of an average M2 obtained by the following formula

$$M2 = \frac{1}{P-S} * \frac{1}{S} * (\sum_{i=1}^{S} i * C_i + \sum_{i=S+1}^{P-S} S * C_i + \sum_{i=P-S+1}^{P-1} (P-i) * C_i)$$

in which S is a first quantity of periods of the reference signal, P a second quantity of periods of the reference signal, P and S being powers of two with S less than P/2, and $C_i$ corresponds to the number of whole periods of said signal (SIG) counted during a current period of the reference signal, and
- a determination of the frequency of said signal (SIG) from said average M2 and the frequency of the reference signal (REF).

12. Device (DIS) for determining the frequency of a signal (SIG) from a periodic reference signal (REF), including processing means configured for performing

a) a count of the number ($C_i$) of whole periods of said signal (SIG) during a first period ($P_i$) of the reference signal (REF),
b) R repetitions of step a) for each other period ($P_i$) of the reference signal (REF) during a first duration equal to a first quantity (S) of periods ($P_i$) of the reference signal (REF),
c) a determination of a first average (M1) of said numbers ($C_i$),
d) R repetitions of at least one part of steps a) to c), at each repetition shifting the start of counting of step a) by at least one period ($P_i$) of the reference signal, optionally taking into account for step b) and step c) the numbers of whole periods of said signal already counted during the at least one preceding group of steps a) and b),
e) a determination of a second average (M2) of all the first averages (M1) thus obtained, and
f) a determination of the frequency of said signal (SIG) from said second average (M2) and the frequency of the reference signal (REF).

13. Device according to Claim 12, in which the processing means are configured for performing the R repetitions of steps a), b) and c) in parallel.

14. Device according to one of Claims 12 and 13, in which the processing means are configured for implementing steps a) to e) by applying the following formula:

$$M2 = \frac{1}{R} * (\sum_{k=1}^{R} \frac{1}{S} \sum_{i=k}^{k+S-1} C_i)$$

in which M2 corresponds to the second average, S corresponds to the first quantity and $C_i$ corresponds to said number of whole periods of said signal counted during a current period of the reference signal.

15. Device according to one of Claims 12 and 13, in which R is equal to a second quantity (P) of periods ($P_i$) of the reference signal (REF) reduced by the first quantity (S).

16. Device according to Claim 15, in which the first quantity (S) and the second quantity (P) are powers of two.

17. Device according to Claim 16, in which the first quantity (S) is half the second quantity (P) and the processing means are configured for implementing steps a) to e) by applying the following formula:

$$M2 = \frac{1}{P-S} * \frac{1}{S} * \left( \sum_{i=1}^{S} i * C_i + \sum_{i=S+1}^{P-1} (P-i) * C_i \right)$$

in which M2 corresponds to the second average, S corresponds to the first quantity, P corresponds to the second quantity, and $C_i$ corresponds to said number of whole periods of said signal counted during a current period of the reference signal.

18. Device for determining the frequency of a signal (SIG) from a periodic reference signal (REF), including processing means configured for

- determining an average M2 obtained by the following formula

$$M2 = \frac{1}{P-S} * \frac{1}{S} * \left( \sum_{i=1}^{S} i * C_i + \sum_{i=S+1}^{P-1} (P-i) * C_i \right)$$

in which S is a first quantity of periods of the reference signal, P a second quantity of periods of the reference signal, P and S being powers of two with S equal to P/2, and $C_i$ corresponds to the number of whole periods of said signal (SIG) counted during a current period of the reference signal, and
- determining the frequency of said signal (SIG) from said average M2 and the frequency of the reference signal (REF).

19. Device according to Claim 17 or 18, in which the processing means comprise

- a counting means (1) configured for delivering said successive numbers ($C_i$) of whole periods of said signal,
- a setpoint counter (2a) configured, during the P-1 reference periods ($P_i$) of the reference signal, for being incremented by one at each new reference period ($P_i$) up to the first quantity (S) then being decremented by one at each new reference period ($P_i$),
- a multiplier (3) having two inputs connected respectively to the outputs of the counting means (1) and the setpoint counter (2),
- an accumulator (4) connected at the output of the multiplier (3) and
- a shifting means (6) connected to the output of the accumulator (4) and configured for performing a bit shift corresponding to the division by the product of S by P-S.

20. Device according to Claim 16, in which the first quantity (S) is less than half the second quantity (8) and the processing means are configured for implementing steps a) to e) by applying the following formula:

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

in which M2 corresponds to the second average, S corresponds to the first quantity, P corresponds to the second quantity, and $C_i$ corresponds to said number of whole periods of said signal counted during a current period of the reference signal.

21. Device for determining the frequency of a signal (SIG) from a periodic reference signal (REF), including processing means configured for

- determining an average M2 obtained by the following formula:

$$M2 = \frac{1}{P-S} * \frac{1}{S} * \left( \sum_{i=1}^{S} i * C_i + \sum_{i=S+1}^{P-S} S * C_i + \sum_{i=P-S+1}^{P-1} (P-i) * C_i \right)$$

in which S is a first quantity of periods of the reference signal, P a second quantity of periods of the reference signal, P and S being powers of two with S less than $\frac{P}{2}$, and $C_i$ corresponds to the number of whole periods of said signal (SIG) counted during a current period of the reference signal, and
- determining the frequency of said signal (SIG) from said average M2 and the frequency of the reference signal (REF).

22. Device according to Claim 20 or 21, in which the processing means comprise

- a counting means (1) configured for delivering said successive numbers ($C_i$),
- a setpoint counter (2b) configured, during the P-1 reference periods (Pi) of the reference signal, for being incremented by one at each new reference period ($P_i$) up to the first quantity (S), then being kept at the first quantity (S) during a number of reference periods equal to the difference between P-1 and 2S, then being decremented by one at each new reference period ($P_i$).
- a multiplier (3) having two inputs connected respectively to the outputs of the counting means (1) and the setpoint counter (2),
- an accumulator (4) connected at the output of the multiplier (3) and
- a shifting means (6) connected to the output of the accumulator (4) and configured for performing a bit shift corresponding to the division by the product of S by P-S.

# FIG.1

# FIG.2

# FIG.3

REF

Vi

1    2    3    4    3    2    1

S      P-1    P

$P_1$    $P_2$    $P_3$    $P_4$    $P_5$    $P_6$    $P_7$    Temps (Pi)

# FIG.4

REF

SIG

$C_1$    $C_2$

$C_2$    $C_3$

$C_3$    $C_4$

$C_4$    $C_5$

$C_5$    $C_6$

$C_6$    $C_7$

S      P-1    P

$P_1$    $P_2$    $P_3$    $P_4$    $P_5$    $P_6$    $P_7$    Temps (Pi)

# FIG.5

# FIG.6

**EP 3 171 183 B1**

## RÉFÉRENCES CITÉES DANS LA DESCRIPTION

**Documents brevets cités dans la description**

*   US 7902891 B1